(19) Europäisches Patentamt / European Patent Office / Office européen des brevets

(11) **EP 1 974 069 B1**

(12) **FASCICULE DE BREVET EUROPEEN**

(45) Date de publication et mention de la délivrance du brevet:
**13.05.2009 Bulletin 2009/20**

(21) Numéro de dépôt: 07717986.9

(22) Date de dépôt: **02.01.2007**

(51) Int Cl.:
*C23C 2/14* *(2006.01)*    *B05C 3/12* *(2006.01)*
*B05D 7/24* *(2006.01)*    *G01B 11/16* *(2006.01)*
*C30B 28/10* *(2006.01)*    *C30B 29/06* *(2006.01)*
*H01L 31/18* *(2006.01)*

(86) Numéro de dépôt international:
**PCT/FR2007/050599**

(87) Numéro de publication internationale:
**WO 2007/083044 (26.07.2007 Gazette 2007/30)**

(54) **TIRAGE SYMÉTRIQUE DE RUBANS COMPOSITES**

SYMMETRISCHES ZIEHEN VON BÄNDERN AUS EINEM VERBUNDMATERIAL

SYMMETRICAL PULLING OF COMPOSITE RIBBONS

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **17.01.2006 FR 0650154**

(43) Date de publication de la demande:
**01.10.2008 Bulletin 2008/40**

(73) Titulaire: **Solarforce**
**38300 Bourgoin Jallieu (FR)**

(72) Inventeur: **BELOUET, Christian**
**F-92330 Sceaux (FR)**

(74) Mandataire: **Lenne, Laurence et al**
**Feray Lenne Conseil**
**39/41, avenue Aristide Briand**
**92163 Antony Cedex (FR)**

(56) Documents cités:
**EP-A- 0 048 688**    **EP-A- 0 141 114**
**WO-A-03/027346**    **US-A- 4 217 165**

- **BELOUET C: "Growth of silicon ribbons by the RAD process" JOURNAL OF CRYSTAL GROWTH NETHERLANDS, vol. 82, no. 1-2, mars 1987 (1987-03), pages 110-116, XP002402138 ISSN: 0022-0248 cité dans la demande**
- **BELOUET C ET AL: "Growth of polysilicon sheets on a carbon shaper by the RAD process" JOURNAL OF CRYSTAL GROWTH NETHERLANDS, vol. 61, no. 3, avril 1983 (1983-04), pages 615-628, XP002402139 ISSN: 0022-0248**

## Description

La présente invention concerne un dispositif pour déposer une couche à base de silicium polycristallin sur un support mobile ainsi que différents procédés de mise en oeuvre d'un tel dispositif.

Elle s'applique typiquement au tirage de rubans de silicium destinés à la fabrication de cellules photovoltaïques, notamment aux rubans composites du type Silicium/Carbone/Silicium.

Dans un exemple de réalisation, les plaques de silicium sont obtenues à partir d'une couche de silicium formant un film qui est déposée sur un ruban de carbone. Ce ruban de carbone traverse en continu un bain de silicium fondu, de préférence verticalement. Après solidification, la bande qui sort du bain est une bande composite constituée d'une âme en carbone insérée entre deux couches de silicium. L'âme en carbone est ultérieurement éliminée par brûlage dans un four à haute température. On obtient ainsi deux rubans de silicium de faible épaisseur qui sont découpés en plaques. Ces plaques subissent ensuite différents traitements conduisant à la réalisation de cellules photovoltaïques.

Ce type de procédé, appelé procédé RST (Ruban sur Substrat Temporaire), est par exemple décrit dans les brevets FR 2 386 359 et FR 2 550 965.

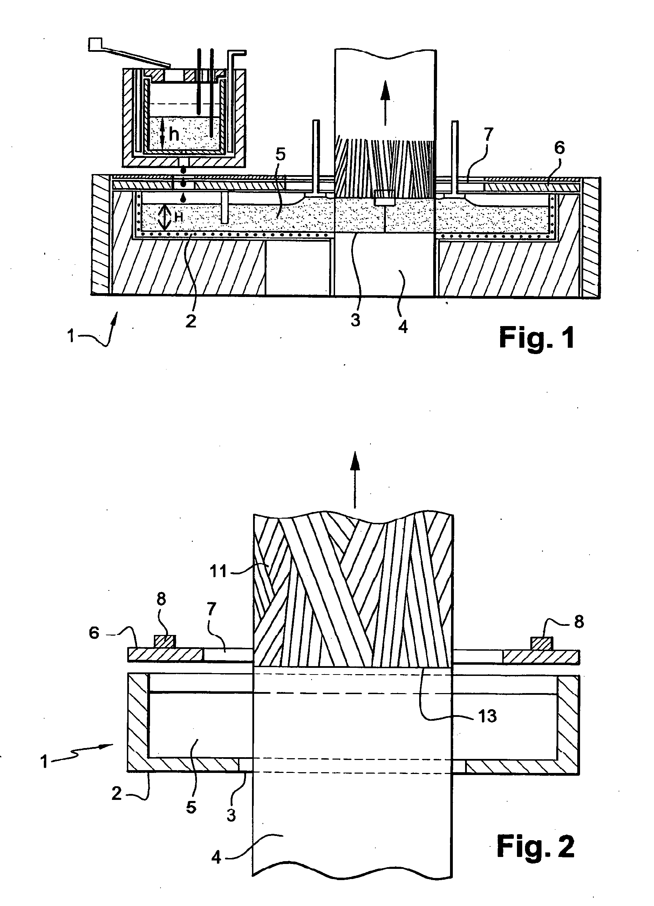

Le document s'intitulant *Growth of silicon ribbons by the rad process* de C. BELOUET, publié dans le Journal of Crystal Growth 82 (1987) 110-116, présente un dispositif du type RST pour déposer une couche de silicium polycristallin sur un ruban de carbone, comme illustré sur la figure 1. Ce dispositif 1 comprend un récipient 2 muni d'un fond horizontal dans lequel est aménagée une fente 3, un ruban de carbone 4 plongé dans un bain 5 de silicium fondu, ledit ruban 4 se déplaçant verticalement vers le haut et traversant la surface d'équilibre du bain 5 de façon à déposer ladite couche sur les deux faces du ruban 4, et un écran thermique 6 obturant le récipient 2 et comportant une ouverture 7 par laquelle est extrait ledit ruban 4 recouvert de silicium.

Cependant, ce dispositif ne permet pas d'obtenir des épaisseurs de silicium constantes et d'égale épaisseur de part et d'autre du ruban de carbone. De ce fait, l'asymétrie engendrée par cette variation d'épaisseur entre les deux faces du ruban entraîne une chute de la productivité. En effet, cette asymétrie entraîne des contraintes d'origine thermoélastique dans le ruban composite au refroidissement et provoque ainsi des fractures dans les couches de silicium et notamment au niveau de la couche ayant l'épaisseur la plus mince.

L'invention vise à résoudre les problèmes de l'art antérieur en proposant un dispositif permettant de diminuer les coûts de fabrication et d'augmenter le taux de production des plaques de silicium. Le dispositif est particulièrement avantageux pour la réalisation de couches de silicium de très faibles épaisseurs, comprises entre 30 et 100 $\mu$m, mais il s'applique également aux plus grandes épaisseurs.

A cet effet, l'invention a pour objet un dispositif pour déposer une couche à base de silicium polycristallin sur un support mobile, allongé et sensiblement plat, comprenant un creuset contenant un bain de silicium fondu, un support comportant deux faces longitudinales et deux bords latéraux longitudinaux, ledit support étant plongé au moins partiellement dans le bain et traversant sensiblement verticalement dans le sens de la longueur la surface d'équilibre du bain, et un écran thermique obturant sensiblement le creuset et comportant une ouverture par laquelle est extrait ledit support recouvert d'une couche à base de silicium polycristallin, ledit dispositif comprenant en outre un organe d'entraînement de l'écran thermique destiné à déplacer ledit écran selon un axe de déplacement sensiblement perpendiculaire à une face longitudinale dudit support afin de contrôler les échanges thermiques entre l'intérieur et l'extérieur du creuset.

Grâce à l'invention, l'asymétrie au niveau des épaisseurs des couches de silicium de part et d'autre du ruban de carbone est corrigée de façon significative, notamment pour les couches de faible épaisseur.

Selon une autre caractéristique, l'organe d'entraînement de l'écran thermique est solidaire d'une table de déplacement motorisée.

L'invention concerne également un premier procédé de mise en oeuvre du dispositif selon l'invention comprenant les étapes suivantes : mesurer, à l'aide d'au moins un moyen de détection optique, une déformation au niveau d'un des bords latéraux longitudinaux du support recouvert d'une couche à base de silicium polycristallin sur chacune de ses faces longitudinales, et déduire à l'aide d'un ensemble d'abaques, à partir de ladite déformation, une amplitude et un sens de déplacement de l'écran selon l'axe de déplacement.

Selon un exemple de caractéristique avantageux, ladite déformation est le déplacement du support parallèlement à l'axe de déplacement de l'écran.

L'invention concerne également un second procédé de mise en oeuvre du dispositif selon l'invention comprenant les étapes suivantes : mesurer, à l'aide d'au moins deux moyens de détection optique, une déformation au niveau de chaque face longitudinale du support recouvert d'une couche à base de silicium polycristallin sur chacune de ses faces longitudinales, et déduire à l'aide d'un ensemble d'abaques, à partir de ladite déformation, une amplitude et un sens de déplacement de l'écran selon l'axe de déplacement.

Selon une caractéristique avantageuse, ladite déformation est le décalage des lignes de raccordement solide-liquide de chaque couche dans un axe perpendiculaire à l'axe de déplacement de l'écran.

Le premier et le second procédés permettent de contrôler et de corriger de façon simple et peu coûteuse l'asymétrie résultant d'une différence d'épaisseur entre les couches de silicium.

Selon un mode particulier de réalisation, le premier et le second procédés comprennent les étapes suivantes : déterminer, à l'aide des abaques, à partir de la mesure de ladite déformation, une valeur du coefficient d'asymétrie, et déterminer, à l'aide des abaques, à partir de ladite valeur, l'amplitude et le sens de déplacement de l'écran selon l'axe de déplacement.

L'invention concerne également un troisième procédé de mise en oeuvre du dispositif selon l'invention comprenant les étapes suivantes : mesurer, à l'aide d'au moins une sonde hyperfréquence, l'épaisseur de chacune des couches à base de silicium polycristallin du support, et déterminer, à l'aide d'un ensemble d'abaques, à partir de la mesure desdites épaisseurs, une amplitude et un sens de déplacement de l'écran selon l'axe de déplacement.

L'invention sera mieux comprise grâce à la description qui suit en référence aux dessins annotés et illustrant divers modes de réalisation.

La figure 1 représente une vue en coupe verticale d'un dispositif selon ' l'art antérieur décrit ci-avant.

La figure 2 représente une vue en coupe verticale d'un dispositif selon l'invention.

La figure 3 représente une vue de dessus d'un écran thermique du dispositif selon l'invention.

La figure 4 représente une vue schématique en coupe verticale d'une face latérale d'un ruban composite selon un type de déformation.

La figure 5 représente une vue schématique en coupe verticale d'une face latérale d'un ruban composite selon un autre type de déformation.

Le tirage RST en continu requiert un certain nombre de conditions préalables connues.

La première condition consiste à ce que le tirage du ruban RST s'effectue suivant une direction sensiblement perpendiculaire à la surface du bain de silicium fondu. Cette condition est obtenue par exemple en maintenant une force de traction adéquate dans une direction opposée à la force de tirage.

La seconde condition provient de la symétrie des ménisques, à partir desquels se forment les films de silicium opposés. Cette condition est obtenue par une distance ruban - parois latérales du creuset d'au moins 30 mm et d'un chauffage du creuset, de préférence par effet Joule.

Cependant, même lorsque toutes ces conditions sont remplies, un tirage non symétrique, c'est-à-dire avec des épaisseurs de silicium différentes de part et d'autre du ruban de carbone, peut encore être observé.

L'origine de cette asymétrie est attribuée à des échanges thermiques différenciés de part et d'autre du ruban de carbone provenant d'un chauffage imparfait du creuset, du transfert thermique par convection entre le ruban composite et le gaz de balayage de l'enceinte et des échanges thermiques radiatifs entre ledit ruban et le milieu environnant.

Même avec des contrôles appropriés tels que par exemple une circulation contrôlée du gaz de balayage dans la zone de cristallisation ou une configuration géométrique optimisée de l'ensemble du four de tirage, des différences d'épaisseur relativement faibles sont toujours présentes. Ces différences peuvent entraîner, notamment dans la couche de silicium la plus mince, des contraintes d'origine thermoélastique susceptibles d'induire des fractures dans ladite couche.

Ces contraintes, dites « résiduelles », croissent rapidement avec le coefficient d'asymétrie $p_{asym}$, notamment dans le cas de tirage où les couches de silicium sont de faible épaisseur. Le coefficient d'asymétrie $p_{asym}$ est défini par le rapport suivant :

$$p_{asym} = (E1 - E2) / Et, \text{ avec } Et = E1 + E2$$

où E1 est l'épaisseur de la couche épaisse de silicium, E2 est l'épaisseur de la couche mince de silicium, et Et est l'épaisseur totale.

L'invention vise donc à éliminer tout problème d'asymétrie au niveau d'un ruban composite du type Silicium/Carbone/Silicium. Le dispositif selon l'invention va agir sur l'asymétrie thermique globale qui est la somme de toutes les asymétries résiduelles précédemment citées.

Pour cela, l'invention propose un dispositif de type RST comprenant un organe d'entraînement de l'écran thermique destiné à déplacer ledit écran selon un axe de déplacement sensiblement perpendiculaire à une face longitudinale dudit ruban composite.

Le déplacement de l'écran, notamment de l'ouverture par laquelle est extrait le ruban composite, permet de contrôler les échanges thermiques entre l'intérieur et l'extérieur du creuset et donc de modifier les échanges thermiques autour de la zone de cristallisation du silicium : l'asymétrie thermique globale est ainsi éliminée.

Ainsi, ce dispositif permet d'obtenir un taux élevé de plaques utilisables : le rendement de fabrication des plaques de silicium est donc amélioré de façon significative. De plus, ce dispositif permet d'accéder à des plaques de silicium d'épaisseur inférieure à 80 $\mu$m avec des vitesses de tirage élevées.

Sur la figure 2, est représenté un creuset 2 parallélépipédique contenant un bain 5 de silicium fondu. Le fond du creuset 2 comporte une fente 3 à travers laquelle passe verticalement un ruban 4 de carbone qui sort du bain 5 en traversant sa surface d'équilibre. Le dispositif 1 comprend, en outre, des moyens de chauffage, non représentés, disposés autour du creuset 2 pour maintenir le silicium à l'état liquide.

Un écran thermique 6 obture sensiblement le creuset 2 et comprend une ouverture 7 par laquelle est extrait le ruban composite 11 Silicium/Carbone/Silicium.

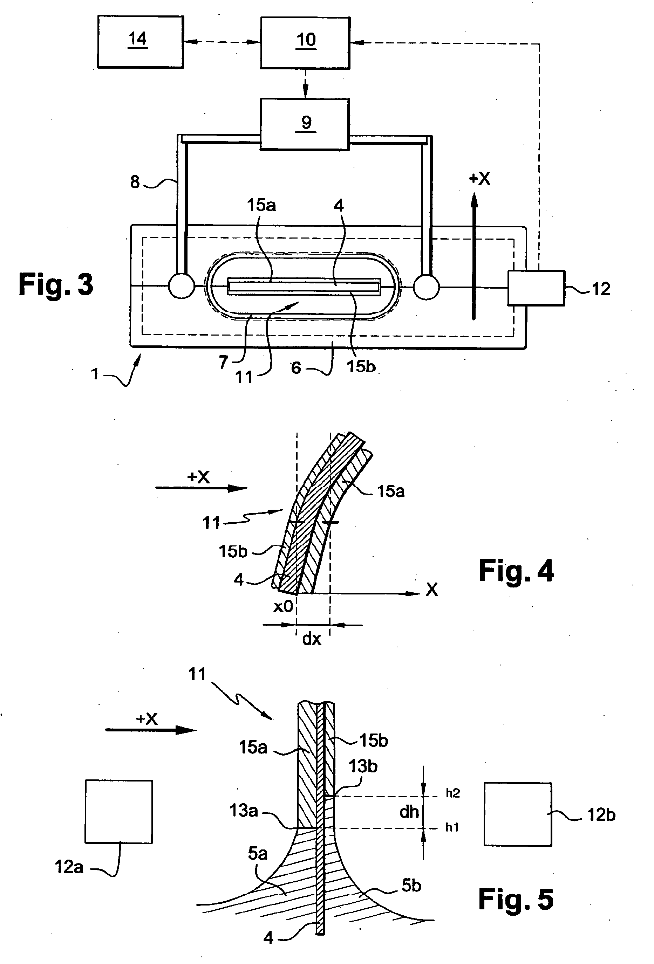

Comme représenté sur les figures 2 et 3, un organe d'entraînement 8, du type élément mécanique rigide en forme de « U », est fixé sur l'écran thermique 6.

Un signal de mesure est envoyé par un moyen de détection 12 à un automate programmable 10.

L'automate programmable 10 traite le signal de mesure à l'aide d'un ensemble d'abaques 14 établis expérimentalement et envoie un signal de commande à un dispositif d'entraînement 9, du type table de déplacement motorisée.

La table de déplacement 9, pilotée par ledit automate 10, supporte l'écran 6 via l'organe d'entraînement 8.

L'écran thermique 6 est ainsi déplacé par l'organe d'entraînement 8 selon un axe de déplacement (axe X) sensiblement perpendiculaire à une face longitudinale du ruban composite 11.

Le sens de déplacement de l'écran 6 est défini par l'épaisseur des couches 15a,15b de silicium du ruban composite 11, pour une hauteur du bain 5 de silicium fondu dans le creuset 2 sensiblement constante et située à quelques millimètres de l'écran thermique 6.

Dans de telles conditions, pour corriger l'asymétrie, il est effectué un déplacement de l'écran 6 vers la couche 15a,15b la plus épaisse, afin de réduire l'espace, entre l'ouverture 7 de l'écran 6 et la face longitudinale dudit ruban composite 11 comprenant cette couche plus épaisse.

En outre, ledit écran 6 est placé à une hauteur ajustable de 0 à quelques millimètres au-dessus du creuset 2, afin de pouvoir le déplacer facilement au-dessus du creuset 2.

Différents procédés permettent de déterminer l'amplitude et le sens de déplacement de l'écran thermique à partir de mesures de grandeurs physiques fonction de l'asymétrie instantanée et sur la base d'un ensemble d'abaques reliant ces grandeurs au coefficient d'asymétrie pour chaque configuration de tirage.

Un premier type de procédé permet de déterminer de façon indirecte l'amplitude et le sens de déplacement de l'écran.

On mesure le déplacement du ruban composite parallèlement à l'axe X par rapport à une valeur de consigne en réponse à sa courbure, générée par l'asymétrie.

Les conditions nominales ou les valeurs de consigne du tirage de rubans RST sont définies par l'obtention, à une vitesse de tirage donnée, d'un film de silicium sur chaque face du ruban de carbone, les épaisseurs des deux couches de silicium étant égales à une valeur prédéfinie constante, de préférence comprise environ entre 50 et 300 $\mu$m.

Comme représenté sur la figure 4, lorsque les couches de silicium opposées ont une épaisseur différente, le ruban composite 11 se courbe au refroidissement en raison des propriétés thermomécaniques différentes du ruban de carbone 4 et des couches 15a,15b de silicium : la valeur du coefficient de dilatation thermique du silicium est plus grande que celle du carbone.

Au refroidissement, la couche de silicium 15a la plus épaisse est ainsi en compression et la couche de silicium 15b la moins épaisse est en extension.

Ainsi, pour réguler le tirage symétrique utilisant cette propriété, on corrige l'asymétrie en mesurant le déplacement algébrique dx du ruban composite 11 dans la direction selon l'axe X, qui est associé à la courbure dudit ruban 11, par rapport à sa position nominale $x_0$.

En se référant à la figure 3, le déplacement algébrique dx du ruban composite 11 est mesuré à l'aide d'un moyen de détection optique 12 du type caméra CCD à haute résolution. Cette caméra est placée à une hauteur fixe située au-dessus de la ligne de raccordement solide-liquide.

Le déplacement algébrique dx est fonction du coefficient d'asymétrie $p_{asym}$, précédemment défini, pour des conditions opératoires données, à savoir l'épaisseur totale Et et notamment, la tension appliquée sur le ruban de carbone.

Le déplacement dx mesuré est envoyé à l'automate programmable 10 de traitement du signal.

L'automate programmable 10 compare le déplacement dx à un déplacement de consigne $dx_0$, puis le corrèle, à l'aide des abaques 14, à une valeur du coefficient d'asymétrie du ruban composite 11.

La valeur du coefficient d'asymétrie est ensuite corrélée, à l'aide des abaques 14, à une amplitude et à un sens de déplacement de l'écran 6 selon l'axe X afin de corriger l'asymétrie.

Selon la figure 4, le sens de déplacement de l'écran 6 s'effectue dans le sens -X puisque la couche de silicium 15a est la plus épaisse.

Enfin, selon la figure 3, l'automate programmable 10 envoie un signal de commande à la table de déplacement 9 motorisée afin de mettre en action l'organe d'entraînement 8.

Un second type de procédé permet également de déterminer de façon indirecte l'amplitude et le sens de déplacement de l'écran.

On corrige l'asymétrie en comparant le décalage vertical entre les lignes de raccordement solide - liquide du ruban composite avec une valeur de consigne.

Comme illustré sur la figure 5, chaque ligne de raccordement 13a,13b au niveau des faces longitudinales du ruban composite 11 se trouve dans un axe perpendiculaire à l'axe X, correspondant respectivement à chacune des couches 15a,15b de silicium dudit ruban 11.

La position de chaque ligne de raccordement solide-liquide 13a,13b est mesurée respectivement à l'aide d'une caméra CCD 12a,12b à haute résolution, placée en vis-à-vis de chaque face longitudinale du ruban composite 11.

Les positions h1 et h2 de chaque ligne sont parfaitement identifiables par contraste de couleur entre le ménisque liquide 5a,5b et la couche 15a,15b de silicium cristallisée.

Dans un exemple particulier, la couche de silicium 15a la plus épaisse est celle dont la ligne de raccordement solide-liquide 13a à la position h1 la plus basse.

Le décalage dh, correspondant à la différence entre les positions h1 et h2, est fonction du coefficient d'asymétrie $p_{asym}$ précédemment défini. La recherche du tirage symétrique, caractérisé par $p_{asym}$ environ égal à zéro, nécessite le maintien de dh à une valeur de référence proche de zéro, notamment de dh inférieure en valeur absolue à 50$\mu$m.

En outre, d'autres moyens de détection optique peuvent être utilisés comme un photodétecteur.

En se référant à la figure 3, le signal de mesure du décalage dh est envoyé à l'automate programmable 10 de traitement du signal.

L'automate programmable 10 compare le décalage dh à un décalage de consigne $dh_0$, puis le corrèle, à l'aide des abaques 14, à une valeur du coefficient d'asymétrie du ruban composite 11.

La valeur du coefficient d'asymétrie est ensuite corrélée, à l'aide des abaques 14, à une amplitude et à un sens de déplacement de l'écran 6 selon l'axe X afin de corriger l'asymétrie.

Selon la figure 5, le sens de déplacement de l'écran 6 s'effectue dans le sens +X puisque la couche de silicium 15a est la plus épaisse.

Enfin, selon la figure 3, l'automate programmable 10 envoie un signal de commande à la table de déplacement 9 motorisée afin de mettre en action l'organe d'entraînement 8.

Un troisième type de procédé, non représenté, permet de déterminer de façon directe l'amplitude et le sens de déplacement de l'écran.

A l'aide de deux sondes hyperfréquences positionnées respectivement de part et d'autre du ruban composite, en vis-à-vis de chacune des faces longitudinales du ruban composite, on mesure respectivement l'épaisseur E1 et E2 de chacune des couches de silicium au-dessus du front de cristallisation.

Les mesures des épaisseurs E1 et E2 sont envoyées à un automate programmable de traitement du signal.

L'automate programmable calcule directement la valeur du coefficient d'asymétrie à partir desdites épaisseurs E1 et E2, puis la corrèle, à l'aide d'un ensemble d'abaques, à une amplitude et un sens de déplacement de l'écran selon l'axe X.

Le signal de commande en résultant est envoyé à une table de déplacement motorisée afin de mettre en action l'organe d'entraînement.

Selon une autre caractéristique non représentée et quel que soit le type de procédé utilisé, l'épaisseur totale du ruban composite est contrôlée continuellement par une caméra CCD placée à une hauteur fixe située au-dessus de la zone de cristallisation.

En effet, après retour au tirage symétrique, il faut s'assurer que l'épaisseur totale Et de silicium déposé est bien comprise dans l'intervalle de consigne, dans la mesure où les échanges thermiques globaux ont été perturbés par la correction.

Cette caméra CCD est interfacée avec un automate programmable pour le traitement des données et l'extraction du signal de commande. L'épaisseur mesurée $E_T$ par la caméra CCD correspond à l'épaisseur totale Et additionnée de l'épaisseur du ruban de carbone Ec.

Cependant, le ruban de carbone, lorsqu'il est extrait du bain de silicium, est également recouvert de silicium sur ses bords latéraux longitudinaux et la mesure de Ec est donc inaccessible par des moyens de mesure directs.

Ainsi, à l'aide de techniques capacitives ou tactiles, on détermine l'épaisseur du ruban de carbone Ec' avant l'entrée dudit ruban dans le creuset et l'épaisseur Ec est déduite de l'épaisseur Ec' sur la base d'un ensemble d'abaques expérimentaux.

La mesure de l'épaisseur $E_T$ est ensuite envoyée à l'automate programmable de traitement du signal.

L'automate programmable compare l'épaisseur $E_T$, corrigée de l'épaisseur Ec définie précédemment, à une épaisseur de consigne $Et_0$.

La différence entre d'une part, l'épaisseur $E_T$ corrigée de l'épaisseur Ec, et d'autre part, l'épaisseur de consigne $Et_0$, est traduite en un signal de commande, qui ramène l'épaisseur du ruban composite à son épaisseur de consigne

plus ou moins 3μm, en modifiant par exemple la puissance de chauffage du creuset à vitesse de tirage constante ou bien la vitesse de tirage à puissance de chauffage constante.

L'invention n'est pas limitée aux modes de réalisations précédentes.

Ainsi, le procédé peut comprendre une boucle de régulation de type PID afin d'ajuster au mieux le déplacement de l'écran thermique.

En outre, bien qu'il soit avantageux d'obtenir simultanément deux films de silicium c'est-à-dire un film par face du ruban, un seul film peut être obtenu en empêchant le dépôt de silicium sur l'une des deux faces du ruban de carbone et le dispositif selon l'invention permet également de contrôler l'épaisseur de la couche de silicium de ce type de ruban.

## Revendications

1. Dispositif (1) pour déposer une couche (15) à base de silicium polycristallin sur un support (4) mobile, allongé et sensiblement plat, comprenant :

   - un creuset (2) contenant un bain (5) de silicium fondu,
   - un support (4) comportant deux faces longitudinales et deux bords latéraux longitudinaux, ledit support étant plongé au moins partiellement dans le bain (5) et traversant sensiblement verticalement dans le sens de la longueur la surface d'équilibre du bain (5), et
   - un écran thermique (6) obturant sensiblement le creuset (2) et comportant une ouverture (7) par laquelle est extrait ledit support (11) recouvert d'une couche (15a,15b) à base de silicium polycristallin,

   **caractérisé en ce que** ledit dispositif (1) comprend en outre un organe (8) d'entraînement de l'écran thermique (6) destiné à déplacer ledit écran (6) selon un axe de déplacement sensiblement perpendiculaire à une face longitudinale dudit support (4,11) afin de contrôler les échanges thermiques entre l'intérieur et l'extérieur du creuset (2).

2. Dispositif selon la revendication 1, **caractérisé en ce que** l'organe d'entraînement (8) de l'écran thermique (6) est solidaire d'une table de déplacement (9) motorisée.

3. Procédé de mise en oeuvre du dispositif selon la revendication 1 ou 2 comprenant les étapes suivantes :

   - mesurer, à l'aide d'au moins un moyen de détection optique (12), une déformation au niveau d'un des bords latéraux longitudinaux du support (11) recouvert d'une couche (15a,15b) à base de silicium polycristallin sur chacune de ses faces longitudinales, et
   - déduire à l'aide d'un ensemble d'abaques (14), à partir de ladite déformation, une amplitude et un sens de déplacement de l'écran (6) selon l'axe de déplacement.

4. Procédé selon la revendication 3, **caractérisé en ce que** ladite déformation est le déplacement du support (11) parallèlement à l'axe de déplacement de l'écran.

5. Procédé de mise en oeuvre du dispositif selon la revendication 1 ou 2 comprenant les étapes suivantes :

   - mesurer, à l'aide d'au moins deux moyens de détection optique (12a,12b), une déformation au niveau de chaque face longitudinale du support (11) recouvert d'une couche (15a,15b) à base de silicium polycristallin sur chacune de ses faces longitudinales, et
   - déduire à l'aide d'un ensemble d'abaques (14), à partir de ladite déformation, une amplitude et un sens de déplacement de l'écran (6) selon l'axe de déplacement.

6. Procédé selon la revendication 5, **caractérisé en ce que** ladite déformation est le décalage des lignes de raccordement (13a,13b) solide-liquide de chaque couche (15a,15b) dans un axe perpendiculaire à l'axe de déplacement de l'écran (6).

7. Procédé selon l'une quelconque des revendications 3 à 6, comprenant les étapes suivantes :

   - déterminer, à l'aide des abaques (14), à partir de la mesure de ladite déformation, une valeur du coefficient d'asymétrie, et
   - déterminer, à l'aide des abaques (14), à partir de ladite valeur, l'amplitude et le sens de déplacement de l'écran (6) selon l'axe de déplacement.

8. Procédé de mise en oeuvre du dispositif selon la revendication 1 ou 2 comprenant les étapes suivantes :

   - mesurer, à l'aide d'au moins une sonde hyperfréquence, l'épaisseur de chacune des couches (15a,15b) à base de silicium polycristallin du support (11), et
   - déterminer, à l'aide d'un ensemble d'abaques (14), à partir de la mesure desdites épaisseurs, une amplitude et un sens de déplacement de l'écran (6) selon l'axe de déplacement.

## Claims

1. A device (1) for depositing a polycrystalline silicon base layer (15) on a mobile, elongated and substantially flat support (4), comprising:

   - a well (2) containing a fused silicon bath (5),
   - a support (4) comprising two longitudinal sides and two longitudinal lateral rims, said support being immerged at least partially into the bath (5) and going through the equilibrium surface of the bath (5) substantially vertically in the lengthwise direction, and
   - a heat shield (6) substantially sealing the well (2) and comprising an opening (7) through which said support (11) is extracted, covered by a polycrystalline silicon base layer (15a, 15b),

   **characterized in that** said device (1) further comprises a member (8) for driving the heat shield (6) designed for moving said shield (6) along an axis of displacement substantially perpendicular to a longitudinal side of said support (4, 11) in order to control the heat exchanges between the inside and the outside of the well (2).

2. The device according to claim 1, **characterized in that** the member (8) for driving the heat shield (6) is integral with a motorized displacement table (9).

3. A method for implementing the device according to claim 1 or 2, comprising the following steps:

   - measuring, by means of at least one optical detection means (12), a deformation at one of the longitudinal side rims of the support (11) covered with a polycrystalline silicon base layer (15a, 15b) on each of the longitudinal sides thereof, and
   - deducing, by means of a set of charts (14), from said deformation, an amplitude and a direction of displacement of the shield (6) along the axis of displacement.

4. The method according to claim 3, **characterized in that** said deformation is the displacement of the support (11) in parallel with the axis of displacement of the shield.

5. A method for implementing the device according to claim 1 or 2, comprising the following steps:

   - measuring, by means of at least two optical detection means (12a, 12b), a deformation at each longitudinal side of the support (11) covered with a polycrystalline silicon base layer (15a, 15b) on each of the longitudinal sides thereof, and
   - deducing, by means of a set of charts (14), from said deformation, an amplitude and a direction of displacement of the shield (6) along the axis of displacement.

6. The method according to claim 5, **characterized in that** said deformation is the shift of the solid/liquid connecting lines (13a, 13b) of each layer (15a, 15b) in an axis perpendicular to the axis of displacement of the shield (6).

7. The method according to any of claims 3 to 6, comprising the following steps:

   - determining, by means of the charts (14), from the measurement of said deformation, a value of the coefficient of asymmetry, and
   - determining, by means of the charts (14), from said value, the amplitude and the direction of displacement of the screen (6) along the axis of displacement.

8. A method for implementing the device according to claim 1 or 2, comprising the following steps:

- measuring, by means of at least one microwave probe, the thickness of each of the polycrystalline silicon base layers (15a, 15b) of the support (11), and
- determining, by means of a set of charts (14), from the measurement of said thicknesses, an amplitude and a direction of displacement of the shield (6) along the axis of displacement.

**Patentansprüche**

1. Vorrichtung (1) zum Absetzen einer auf Polykristallsilizium basierenden Schicht (15) auf einen beweglichen, länglichen und im Wesentlichen flachen Träger (4), umfassend:

   - einen Schmelztiegel (2), der ein Bad (5) von Siliziumschmelze enthält,
   - einen Träger (4), der zwei Längsseiten und zwei Längsseitenränder umfasst, wobei der Träger mindestens teilweise in das Bad (5) eingetaucht wird und im Wesentlichen senkrecht in Längsrichtung die Gleichgewichtsfläche des Bads (5) durchquert, und
   - einen Wärmeschild (6), der den Schmelztiegel (2) im Wesentlichen verschließt und eine Öffnung (7) umfasst, durch die der Träger (11) entnommen wird, der mit einer auf Polykristallsilizium basierenden Schicht (15a, 15b) bedeckt ist,

   **dadurch gekennzeichnet, dass** die Vorrichtung (1) ferner ein Organ (8) zum Mitnehmen des Wärmeschilds (6) umfasst, das dazu gedacht ist, den Schild (6) an einer Verschiebungsachse entlang im Wesentlichen rechtwinklig zu einer Längsseite des Trägers (4, 11) zu verschieben, um die Wärmeaustauschvorgänge zwischen dem Innern und dem Äußern des Schmelztiegels (2) zu regeln.

2. Vorrichtung nach Anspruch 1, **dadurch gekennzeichnet, dass** das Organ (8) zum Mitnehmen des Wärmeschilds (6) mit einer motorisierten Verschiebeplatte (9) fest verbunden ist.

3. Verfahren zur Anwendung der Vorrichtung nach Anspruch 1 oder 2, umfassend folgende Schritte:

   - Messen anhand mindestens eines optischen Erfassungsmittels (12) einer Verformung an einem der Längsseitenränder des Trägers (11), der auf seinen beiden Längsseiten mit einer auf Polykristallsilizium basierenden Schicht (15a, 15b) bedeckt ist, und
   - Ableiten anhand einer Gruppe von Rechentafeln (14), ausgehend von der Verformung, einer Amplitude und einer Verschiebungsrichtung des Schilds (6) entlang der Verschiebungsachse.

4. Verfahren nach Anspruch 3, **dadurch gekennzeichnet, dass** die Verformung die Verschiebung des Trägers (11) parallel zur Verschiebungsachse des Schilds ist.

5. Verfahren zur Anwendung der Vorrichtung nach Anspruch 1 oder 2, umfassend folgende Schritte:

   - Messen anhand von mindestens zwei optischen Erfassungsmitteln (12a, 12b) einer Verformung an jedem Längsseitenrand des Trägers (11), der auf seinen beiden Längsseiten mit einer auf Polykristallsilizium basierenden Schicht (15a, 15b) bedeckt ist, und
   - Ableiten anhand einer Gruppe von Rechentafeln (14), ausgehend von der Verformung, einer Amplitude und einer Verschiebungsrichtung des Schilds (6) entlang der Verschiebungsachse.

6. Verfahren nach Anspruch 5, **dadurch gekennzeichnet, dass** die Verformung die Verschiebung der festen und flüssigen Verbindungslinien (13a, 13b) jeder Schicht (15a, 15b) in einer zur Verschiebungsachse (6) rechtwinkligen Achse ist.

7. Verfahren nach einem der Ansprüche 3 bis 6, umfassend folgende Schritte:

   - Bestimmen anhand der Rechentafeln (14), ausgehend von der Messung der Verformung, eines Werts des Asymmetriekoeffizienten, und
   - Bestimmen anhand der Rechentafeln (14), ausgehend von diesem Wert, der Amplitude und der Verschiebungsrichtung des Schilds (6) entlang der Verschiebungsachse.

8. Verfahren zur Anwendung der Vorrichtung nach Anspruch 1 oder 2, umfassend folgende Schritte:

- Messen, anhand mindestens einer UHF-Sonde der Dicke jeder der auf Polykristallsilizium basierenden Schichten (15a, 15b) des Trägers (11), und
- Bestimmen, anhand einer Gruppe von Rechentafeln (14), ausgehend von der Messung dieser Dicken, einer Amplitude und einer Verschiebungsrichtung des Schilds (6) entlang der Verschiebungsachse.

**Fig. 1**

**Fig. 2**

**Fig. 3**

14

10

9

8

15a    4

+X

12

1

7

11    6    15b

---

+X

11

15a

15b

4

X

x0

dx

**Fig. 4**

---

11

+X

15a    15b

13b

13a    h2

dh

12a    h1    12b

5a

5b

4

**Fig. 5**

---

11

## RÉFÉRENCES CITÉES DANS LA DESCRIPTION

**Documents brevets cités dans la description**

- FR 2386359

- FR 2550965

**Littérature non-brevet citée dans la description**

- **C. BELOUET.** *Journal of Crystal Growth,* 1987, vol. 82, 110-116